# EUROPEAN PATENT SPECIFICATION

(11) **EP 4 168 830 B1**
(45) Date of publication and mention of the grant of the patent: **21.10.2026**
(21) Application number: 21826877.9
(22) Date of filing: 21.06.2021
(51) Int. Cl.: G01V 13/00, G01V 3/30, G01V 3/38, E21B 47/022, H01Q 1/04, G01R 35/00, G01V 3/28

(54) **ANTENNA CALIBRATION IN AN EM LOGGING TOOL**
ANTENNENKALIBRIERUNG IN EINEM EM-PROTOKOLLIERUNGSWERKZEUG
ÉTALONNAGE D'ANTENNE DANS UN OUTIL DE DIAGRAPHIE ÉLECTROMAGNÉTIQUE

(30) Priority: 19.06.2020 US 202062705271 P
(43) Date of publication of application: 26.04.2023
(73) Proprietor: Services Pétroliers Schlumberger, 75007 Paris (FR); Schlumberger Technology B.V., 2514 JG The Hague (NL)
(72) Inventor: TAN, Kong Hauw Sarwa Bakti, Sugar Land, Texas 77478 (US); HE, Qingyan, Sugar Land, Texas 77478 (US); ZHANG, Qing, Sugar Land, Texas 77478 (US); ZHANG, Desheng, Sugar Land, Texas 77478 (US); HARMS, Kent, Sugar Land, Texas 77478 (US); FERNANDEZ, Daniel, Sugar Land, Texas 77478 (US)
(74) Representative: Schlumberger Intellectual Property Department
(86) International application number: PCT/US2021/038233
(87) International publication number: WO 2021/258047

(56) References cited:
- EP-B1- 1 810 058
- WO-A1-2017/074346
- US-A- 5 293 128
- US-A- 5 293 128
- US-A1- 2004 113 609
- US-A1- 2008 054 906
- US-A1- 2008 054 906
- US-A1- 2011 234 230
- US-A1- 2014 156 211
- US-A1- 2014 156 211
- US-A1- 2016 170 068
- US-A1- 2019 137 646

## Description

### BACKGROUND

Early logging tools were run into a wellbore on a wireline cable, after the wellbore had been drilled. Modern versions of such wireline tools are still used extensively. However, the need for information while drilling the borehole gave rise to measurement-while-drilling (MWD) tools and logging-while-drilling (LWD) tools. MWD tools commonly provide drilling parameter information such as weight on the bit, torque, temperature, pressure, direction, and inclination. LWD tools commonly provide formation evaluation measurements such as resistivity, porosity, and NMR distributions. MWD and LWD tools often have components common to wireline tools (e.g., transmitting and receiving antennas), but MWD and LWD tools must be constructed to not only endure but to operate in the harsh environment of drilling.

Electromagnetic (EM) logging measurements are commonly made during drilling operations. Such techniques may be utilized to determine a subterranean formation resistivity, which, along with formation porosity measurements, may be used to indicate the presence of hydrocarbons in the formation. Moreover, azimuthally sensitive directional resistivity measurements are commonly employed e.g., in pay-zone steering applications, to provide information upon which steering decisions may be made.

Electromagnetic logging tools are commonly calibrated to account for imperfections in tool construction and gain variations due to tool electronics. The intent of the calibration is to eliminate and/or compensate for the effects of these factors on the measurement data. For example, air calibration methods are commonly employed in which an electromagnetic resistivity tool is suspended in the air (e.g. via crane) away from any conducting media. A resistivity measurement should yield near-infinite resistivity with any deviation being subtracted and assumed to be related to systematic measurement errors (e.g., related to the electronics, hardware, or processing methods). Mathematical models of the logging tool configuration are also sometimes employed in calibration procedures.

US2008/054906 A1 describes the determination of misalignment of the transmitter and receiver coils of an induction logging tool by positioning the logging tool with a coil axially encompassing the transmitter coil and/or the receiver coil and activating the transmitter at a plurality of rotational angles. US 5293128 A describes a calibration fixture for an MWD logging tool consisting of a plurality of concentric co-planar conductive calibration loops that are mounted around the logging tool mandrel coaxially. The calibration loops are terminated with a multiple-tap impedance quantizing means for discretely varying the impedance of the calibration loops. When a transmitter is activated to emit an electromagnetic signal, the calibration loops are excited to reradiate a portion of that signal into the receivers with an intensity that is a function of the loop impedance thereby to simulate the effects of formations having known resistivities. Other calibration systems and methods for electromagnetic logging tools are described in US 2014/156211 A1, US 2019/137646 A1, US 2004/113609 A1, EP 1810058 B1 and US 2016/170068 A1.

### SUMMARY

The present invention resides in a method for calibrating an electromagnetic measurement tool as defined in claim 1. Preferred embodiments are defined in the dependent claims.

### BRIEF DESCRIPTION OF THE DRAWINGS

For a more complete understanding of the disclosed subject matter, and advantages thereof, reference is now made to the following descriptions taken in conjunction with the accompanying drawings, in which:
FIG. 1 depicts an example of a drilling system.
FIGS. 2A and 2B depict example electromagnetic measurement tools suitable for use in the drilling system of FIG. 1.
FIG. 3 depicts a flow chart of one example method embodiment for calibrating at least one antenna in an electromagnetic measurement tool.
FIG. 4 depicts a cross sectional view of an example test loop deployed about an antenna on an example electromagnetic measurement tool.
FIG. 5 depicts a cross sectional view of the test loop shown on FIG. 4.
FIG. 6 depicts a schematic of a calibration assembly including the test loop, the electromagnetic antenna, and corresponding electronics.
FIGS. 7A, 7B, and 7C depict axial (7A), transverse (7B), and tilted (7C) test loops deployed about an example antenna.
FIG. 8 depicts an example computer system.

### DETAILED DESCRIPTION

Disclosed embodiments relate generally to downhole electromagnetic measurement methods and downhole electromagnetic measurement tools (e.g., resistivity logging while drilling tools) used in making electromagnetic measurements of a subterranean formation. When making downhole electromagnetic measurements, understanding the magnetic moment mismatch among multiple antennas in the electromagnetic tools (e.g., resistivity tools) may aid in determining a measurement. For example, in some applications, such as deep (or extra-deep) boundary detection, and/or 2D/3D reservoir imagining, only relatively small measurement errors may be acceptable. Traditional calibrations are not practical in some tools where there is a very large volume of investigation and the transmitter receiver systems are spaced apart. While some calibration procedures are in commercial use, the inventors identified a need for improved electromagnetic logging tool calibration methods. In some embodiments, the inventors disclose herein a method having improved accuracy that does not require complex mathematical or empirical models of the logging tool. A test loop and data acquisition system are provided to calibrate measurement tool antennas. For example, in embodiments including multiple receiver antennas, the receiver antennas are calibrated with respect to one another using a test loop and data acquisition system.

Disclosed methods include deploying the test loop about a first antenna in the electromagnetic measurement tool and inductively coupling the test loop and the antenna. A first induced voltage is measured in the first antenna or in the test loop while coupling. The test loop is then deploying about a second antenna. The test loop and second antenna are inductively coupled and a second induced voltage is measured in the second antenna or the test loop while coupling. A ratio of the first voltage to the second voltage is computed. The ratio is used to calibrate the first antenna with respect to the second antenna.

The ratio is programmed into the measurement tool and used to correct for magnetic moment mismatch between the first and second antenna (i.e., to calibrate the first antenna with respect to the second antenna or vice versa). The disclosed embodiments advantageously provide for improved measurement accuracy by calibrating one antenna with respect to another (e.g., with respect to an adjacent antenna of similar construction). Moreover, the calibration is advantageously performed without the use of an electromagnetic coupling model, without calibration between receiver subs, and without calibration between the transmitter and receiver subs.

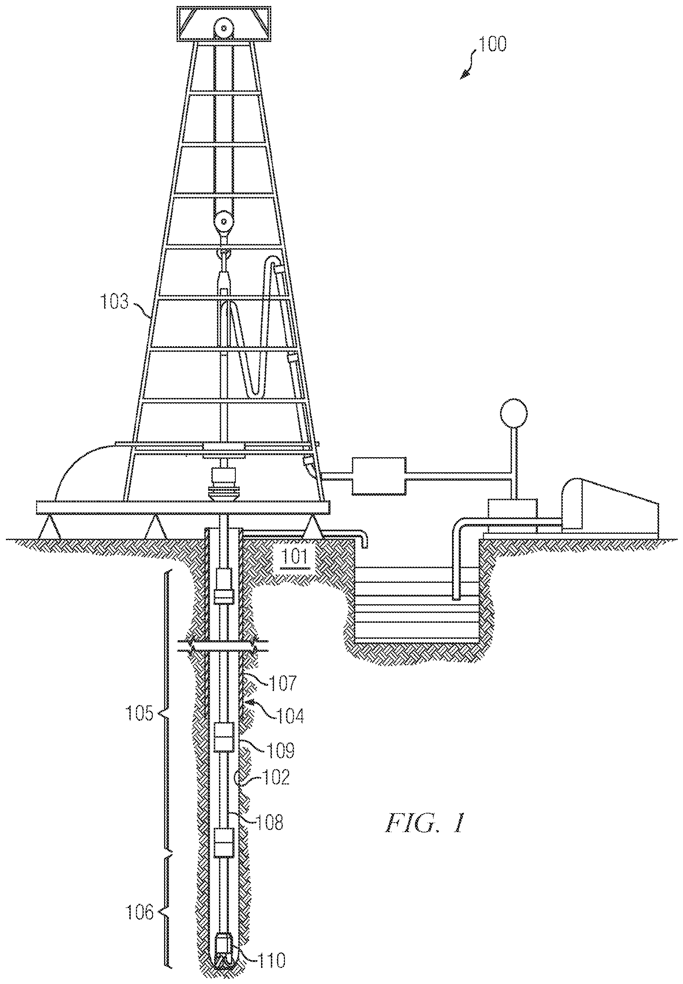

FIG. 1 shows one example of a drilling system 100 for drilling an earth formation 101 to form a wellbore 102. The drilling system 100 includes a drilling rig 103 used to turn a drilling tool assembly 104 which extends downward into the wellbore 102. The drilling tool assembly 104 may include a drill string 105, a bottomhole assembly (BHA) 106, and a drill bit 110, attached to the downhole end of drill string 105.

The drill string 105 may include several joints of drill pipe 108 connected end-to-end through tool joints 109. The drill string 105 transmits drilling fluid through a central bore and transmits rotational power from the drilling rig 103 to the BHA 106. In some embodiments, the drill string 105 may further include additional components such as subs, pup joints, etc. The drill pipe 108 provides a hydraulic passage through which drilling fluid is pumped from the surface. The drilling fluid discharges through selected-size nozzles, jets, or other orifices in the bit 110 for the purposes of cooling the bit 110 and cutting structures thereon, and for lifting cuttings out of the wellbore 102 as it is being drilled.

The BHA 106 may include the bit 110 or other components. An example BHA 106 may include additional or other components (e.g., coupled between to the drill string 105 and the bit 110). Examples of additional BHA components include drill collars, stabilizers, measurement-while-drilling (MWD) tools, logging-while-drilling (LWD) tools such as an electromagnetic measurement tool, downhole motors, underreamers, section mills, hydraulic disconnects, jars, vibration or dampening tools, other components, or combinations of the foregoing. The BHA 106 may further include a rotary steerable system (RSS). The RSS may include directional drilling tools that change a direction of the bit 110, and thereby the trajectory of the wellbore.

In general, the drilling system 100 may include other drilling components and accessories, such as special valves (e.g., kelly cocks, blowout preventers, and safety valves). Additional components included in the drilling system 100 may be considered a part of the drilling tool assembly 104, the drill string 105, or a part of the BHA 106 depending on their locations in the drilling system 100.

The drill bit 110 in the BHA 106 may be any type of bit suitable for degrading downhole materials. For instance, the bit 110 may be a drill bit suitable for drilling the earth formation 101. Example types of drill bits used for drilling earth formations are fixed-cutter or drag bits. In other embodiments, the bit 110 may be a mill used for removing metal, composite, elastomer, other materials downhole, or combinations thereof. For instance, the bit 110 may be used with a whipstock to mill into casing 107 lining the wellbore 102. The bit 110 may also be a junk mill used to mill away tools, plugs, cement, other materials within the wellbore 102, or combinations thereof. Swarf or other cuttings formed by use of a mill may be lifted to surface, or may be allowed to fall downhole.

It will be understood by those of ordinary skill in the art that the deployment illustrated on FIG. 1 is merely an example. For example, disclosed embodiments are not limited to logging while drilling operations. The antenna calibrations as described herein may also be used while using a drill string in wash down mode where drilling is not actively occurring, with wireline logging tools after drilling a wellbore, or at any other time.

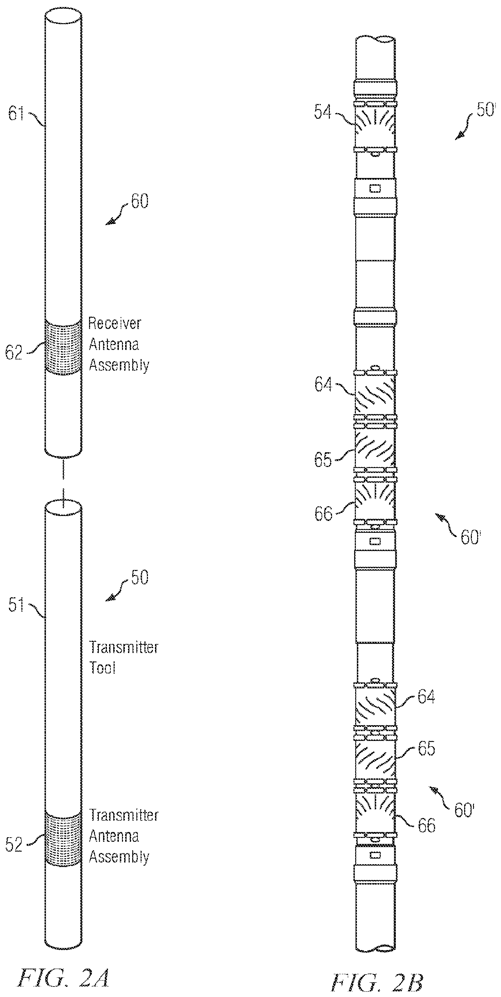

FIGS. 2A and 2B depict example electromagnetic logging tool embodiments that may be deployed, for example, in the BHA 106 depicted on FIG. 1. In some electromagnetic logging tools (e.g., LWD resistivity tools), transmitter receiver spacings can be modified such that the transmitter is spaced from about 10 to more than 200 feet away from one or more receivers, depending on the measurement application/objectives. One example, of a modular tool configuration is depicted on FIG. 2A. The depicted electromagnetic measurement tool embodiment includes transmitter and receiver subs 50 and 60. A transmitter sub (or tool) 50 includes an electromagnetic transmitter 52 deployed on a transmitter collar 51. A receiver sub (or tool) 60 includes an electromagnetic receiver 62 deployed on a receiver collar 61. When deployed in a drill string (e.g., drill string 105 on FIG. 1), the transmitter and receiver subs 50 and 60 may be axially spaced apart substantially any suitable distance to achieve a desired measurement depth (e.g., in a range from about 10 to about 100 or 200 feet or more depending on the measurement objectives). Moreover, multiple receiver subs may be used. While not shown, one or more other BHA tools (such as other LWD tools) may be deployed between the subs 50 and 60.

FIG. 2B depicts an embodiment including a single transmitter sub 50' and multiple receiver subs 60'. In the depicted embodiment, the transmitter sub 50' includes a tilted transmitting antenna 54 and each of the receiver subs 60' includes three (first, second, and third) tilted receiving antennas 64, 65, and 66 azimuthally offset (rotated) from one another by about 120 degrees. It will of course be understood that the disclosed embodiments are not limited to embodiments employing tilted antennas. Substantially any suitable antennas may be utilized, for example, including axial antennas, transverse antennas, and tilted antennas.

As is known to those of ordinary skill in the art, an axial antenna is one whose moment is substantially parallel with the longitudinal axis of the tool. Axial antennas are commonly wound about the circumference of the logging tool such that the plane of the antenna is substantially orthogonal to the tool axis. A transverse antenna is one whose moment is substantially perpendicular to the longitudinal axis of the tool. A transverse antenna may include, for example, a saddle coil (e.g., as disclosed in U.S. Patent Publications 2011/0074427 and 2011/0238312). Tilted antennas are commonly wound about the circumference of the logging tool such that the plane of the antenna is angled (or tilted) with respect to the tool axis (e.g., at an angle of about 45 degrees). Each of the above antenna configurations are well known in the industry.

With reference again to FIG. 2B, example electromagnetic logging tools may include substantially any suitable number of transmitter and receiver subs including substantially any number of corresponding transmitting and receiving antennas. For example only, the depicted electromagnetic logging tool includes a single transmitter sub 50' and a plurality of spaced apart receiver subs 60' (e.g., a plurality of receiver subs each of which includes first, second, and third tilted receiving antennas). The disclosed embodiments are, of course, not limited in these regards.

According to the described embodiments the terms "transmitter" and "receiver" are used to describe different functions of an antenna, as if they were different types of antennas. It will be understood that this is for illustration purposes. A transmitting antenna and a receiving antenna have the same physical characteristics, and one of ordinary skill in the art would appreciate that the principle of reciprocity applies and that a radiating element may be used as a transmitter at one time and as a receiver at another. Thus, any specific description of transmitters and receivers in a particular tool embodiment should be construed to include the complementary configuration, in which the "transmitters" and the "receivers" are switched. Furthermore, in this description, a "transmitter" or a "receiver" is used in a general sense and may include a single radiating element, two radiating elements, or three radiating elements.

It will be further understood that during electromagnetic measurements, a transmitting antenna and a receiving antenna are electromagnetically coupled to one another. For example, the transmitting antenna is energized (e.g., with an alternating electrical current) and an induced voltage is measured on the receiving antenna. Of course, based on reciprocity, the receiving antenna may be equivalently energized and an induced voltage measured on the transmitting antenna. The disclosed embodiments are explicitly not limited in these regards.

The use of electromagnetic measurements (e.g., propagation and induction measurements) is known in the downhole drilling arts. In such measurements, transmitting and receiving antennas are electromagnetically coupled via firing a transmitting antenna (applying a time varying electric current to the antenna) to produce a corresponding time varying magnetic field in the local environment (e.g., the tool collar and the formation). The magnetic field in turn induces electrical currents (eddy currents) in the conductive formation. These eddy currents further produce secondary magnetic fields which may produce a voltage response in a receiving antenna. The measured voltage(s) in the receiving antennas can be processed, as is known to those of ordinary skill in the art, to obtain one or more properties of the formation. As noted above, electromagnetic measurements may make use of substantially any suitable antenna configuration, for example, one or more axial, transverse, tilted, biaxial, and/or triaxial antenna arrangements.

With continued reference to FIGS. 2A and 2B, it will be appreciated that certain ones of the transmitting and receiving antennas in an electromagnetic logging tool have similar construction and may be intended to have the same size and shape such that they have substantially identical magnetic moments. However, variations in antenna dimensions that commonly result from manufacturing tolerances can lead to magnetic moment variations, which in turn can lead to measurement variation (or errors) from one antenna to another (e.g., variation in the measured amplitude and/or phase from one antenna to another) when making electromagnetic measurements. In certain embodiments (and applications) correction of the errors resulting from these variations may improve measurement accuracy. Traditional air calibration methods and modeling calibration methods may be unsuitable for achieving a highly accurate and reliable calibration.

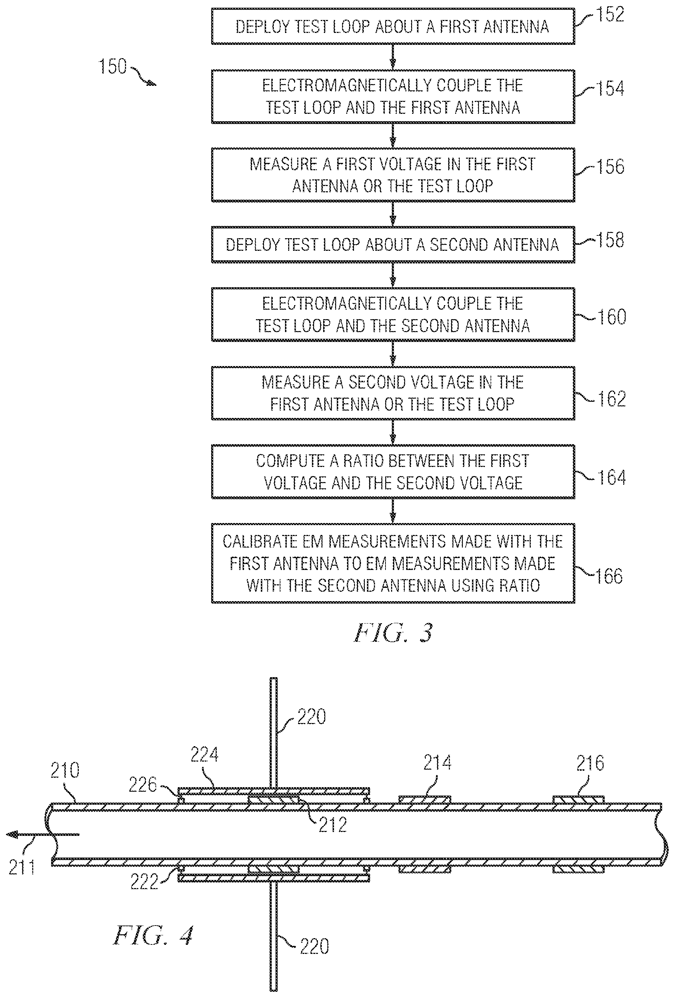

FIG. 3 depicts a flow chart of one example method embodiment 150 for calibrating at least one antenna (e.g., antennas 64, 65, and 66) in an electromagnetic measurement tool. As described in more detail below, a test loop is deployed about a first antenna in the electromagnetic measurement tool at 152. The test loop and the first antenna are electromagnetically coupled at 154 and a corresponding induced voltage is measured at 156 in the test loop or the first antenna. For example, an alternating current is generated in the test loop at 154 to induce a corresponding alternating voltage in the first antenna which is measured at 156. In some embodiments, an alternating current is generated in the first antenna at 154 and the corresponding induced voltage measured in the test loop at 156.

The test loop is then deployed about a second antenna in the electromagnetic measurement tool at 158 (e.g., by moving the test loop axially along the tool from the first antenna to the second antenna). The test loop and the second antenna are electromagnetically coupled at 160 and a corresponding voltage is measured at 162 in the test loop or the second antenna. As described above, an alternating current is generated in the test loop or the second antenna at 160 and the corresponding alternating voltage measured in the second antenna or test loop at 162.

A ratio (also sometimes referred to as a gain ratio or a gain correction ratio) is computed in 164 between the first voltage measured at 156 and the second voltage measured at 162. This ratio is used to calibrate at 166 electromagnetic (EM) measurements made with the first antenna to electromagnetic measurements made with the second antenna. As described in more detail below, voltage measurements made with the first antenna are multiplied by the ratio to calibrate the measurements with corresponding measurements made with the second antenna.

FIG. 4 depicts a cross sectional view of an example test loop 220 deployed about an example electromagnetic measurement tool 210 including first, second, and third adjacent antennas 212, 214, and 216. In the depicted embodiment, the test loop 220 is deployed about the first antenna 212. Measurement tool 210 includes, for example, receiver sub 60 (FIG. 2B) with the first, second, and third antennas 212, 214, and 216 corresponding to the first, second, and third tilted receiving antennas 64, 65, and 66 (although the disclosed embodiments are expressly not limited in this regard). While substantially any suitable test loop may be employed, test loop 220 may advantageously include an axial test loop (having a moment that is parallel or coincident with an axis 211 of the measurement sub 210). The test loop may, in some embodiments, include a tilted test loop.

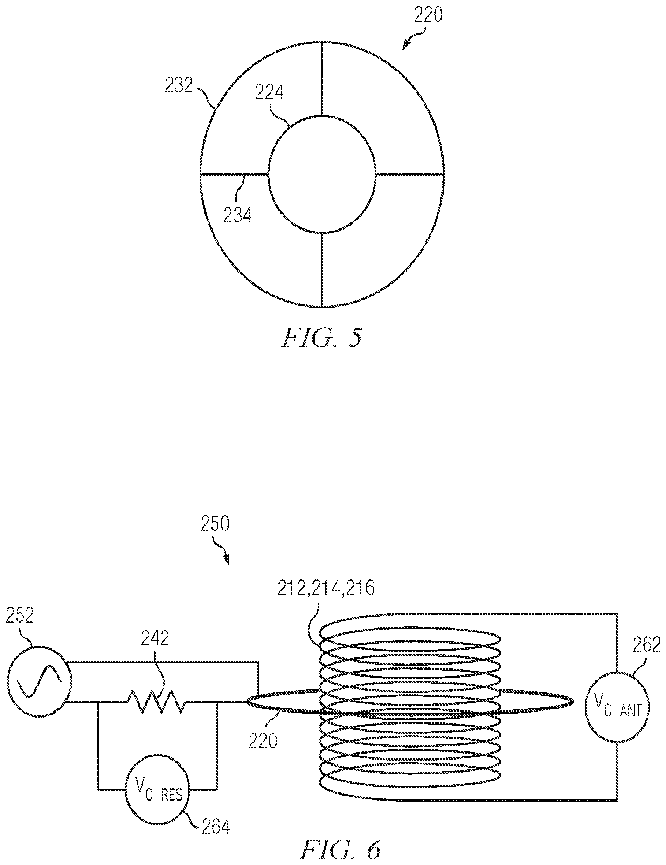

FIG. 5 depicts a cross sectional view of test loop 220 in which the cross section is orthogonal to that shown in FIG. 4 (i.e. looking up or down the measurement tool axis 211). The test loop 220 may include one or more wraps of antenna wire 232, spaced apart from the antenna 212 (FIG. 4) via support members 234 and a circular guide (not shown). It will be understood that the guide and antenna wire 232 of the test loop 220 are not necessarily circular (e.g., the guide and antenna wire may be elliptical in a tilted test loop).

With continued reference to FIGS. 4 and 5, the calibration is performed via installing (deploying) the test loop 220 over the tool antenna 212, (e.g., with the wrap(s) of antenna wire 232 encircling the tubular antenna 212 as depicted on FIG. 4).Such installation (deployment) of the test loop 220 may be performed with high placement accuracy and/or repeatability. Such high placement accuracy and repeatability can be achieved any number of ways, for example, using alignment features on the measurement sub body 210, using alignment rings that align with features on the measurement sub body 210, using an alignment sleeve 224 attached to the test loop 220 that aligns with features on the sub body 210 or alignment rings, and/or any combination of the above. For example, as depicted on FIG. 4, the test loop may be deployed on an alignment sleeve 224 that is configured (sized and shaped) for deployment about the measurement sub 210. Alignment rings 222 may be deployed on the measurement tool 210 at predetermined locations on the tool or may have features that mate with the tool body 210 at designated locations. The alignment sleeve 224 may have openings that align with openings in the alignment rings 222. Pins 226 may be inserted to secure the test loop 220 in location with respect to antenna 212. Other suitable alignment methods may, of course, be utilized. The test loop installation and alignment procedure may be followed with each of the antennas on the measurement tool 210.

FIG. 6 depicts a schematic of an example calibration assembly 250 including the test loop 220, the tool antenna 212, and corresponding electronics. In this particular schematic, the test loop 220 is configured as a transmitter and the tested antenna 212 is configured as a receiver (although as noted above the disclosed embodiments are not limited in this regard). The test loop 220 and a normalizing resistor 242 are connected in series with a signal generator 252. The signal generator 252 is energized to apply an alternating current through the test loop 220 and the resistor 242 and thereby to transmit an electromagnetic field about the antenna 212. The induced voltage in the antenna 212 is measured, for example, using voltage sensor 262. The voltage drop across the resistor 242 may also be measured, for example, using voltage sensor 264. It will be understood that voltage sensor 262 and voltage sensor 264 may be the same voltage sensor and that the assembly may include a switch (or switching assembly) configured to connect the voltage sensor to either the antenna 212 or the resistor 242.

The signal generator 252 may be configured to generate the alternating current at substantially any suitable frequency or frequencies. Electromagnetic measurement tools are commonly configured to make electromagnetic measurements at multiple distinct measurement frequencies, e.g., at 3, 4, 6, or 8 distinct frequencies. For example, some tool embodiments may be configured to make electromagnetic measurements at 1 kHz, 2 kHz, 3 kHz, 6 kHz, 12 kHz, 24 kHz, 48 kHz, 96 kHz, and/or 192 kHz (or at any other desired frequencies). It may therefore be advantageous to configure the signal generator 252 to generate the alternating current at the one or more particular frequencies at which the tool is configured to make measurements thereby enabling the tool to be calibrated at those frequencies.

With reference again to FIG. 3, the electromagnetic coupling in 154 and 160 may be performed at the particular frequency (or frequencies) at which the tool is configured to make electromagnetic measurements. For example, the electromagnetic coupling and corresponding voltage measurements may be made at 154 and 156 (and at 160 and 162) at substantially any number of suitable frequencies (e.g., those frequencies listed above). The electromagnetic coupling and voltage measurements may be made at a first frequency. And then a second frequency. And so on. Ratios may then be computed at 164 at each of the frequencies such that the electromagnetic measurements may be calibrated at each of the frequencies in 166.

Upon securing the test loop 220 to the measurement sub 210 (about the antenna 212) the sub 210 and test loop 220 may be lifted away from metallic objects to reduce or eliminate interference from those objects. For example, the collar may be lifted at least 8 feet (~2.5 m) and thereby moved up and away from the floor, ceiling, walls, and large metallic/magnetic objects.

A data acquisition system is connected to the test loop and the antenna 212 (either before or after lifting the assembly). The acquisition system is configured to measure the voltage (e.g., the amplitude or the amplitude and phase) across the antenna 212 and the voltage (e.g., the amplitude or the amplitude and phase) across the normalizing resistor 242 when the signal generator is energized. The data acquisition system may include a reference from the signal generator 252 to enable measurement of the phase delay between the alternating current in the test loop 220 and the measured voltage in the antenna 212. The signal generator 252 and data acquisition system may be integrated into a single device or may be located in separate devices.

With continued reference to FIG. 3, the test loop 220 and the antenna are electromagnetically coupled at 154 while the assembly is lifted via energizing the signal generator. The data acquisition system measures the complex voltage (e.g., including amplitude and phase) in the first antenna 212 and the complex voltage across the normalizing resistor 242 at 156. As noted above, the electromagnetic coupling and corresponding voltage measurements may be performed at substantially any number of frequencies at which the tool operates. In some embodiments, the electromagnetic coupling and voltage measurements may be performed at each of the frequencies at which the tool operates.

Once the first antenna has been tested at all desired frequencies, the assembly may be lowered and the test loop 220 (and associated alignment systems) moved to the next (second) antenna 214. The assembly may then be lifted again and the data acquisition system connected as described above. An identical procedure may then be followed to electromagnetically couple the test loop 220 and the second antenna 214 and to measure corresponding complex voltages in the second antenna 214 and across the normalizing resistor 242 at the one or more desired frequencies. This procedure may then be optionally followed for a third antenna 216 and substantially any number of other antennas as desired.

As described above, the disclosed calibration procedure calibrates one antenna (e.g., the first antenna) with respect to another antenna (e.g., the second antenna). In this calibration, the gain (e.g., the moment) of the first antenna is normalized to that of the second antenna. For example, in the embodiment described above with respect to FIGS. 2B and 4, the middle antenna (the second antenna) 214 may be used as the reference antenna and the gain of the first antenna 212 and the third antenna 216 may be adjusted by a ratio (or gain ratio) so that the gain (or moment) is equalized across the three antennas. Antenna gain ratios between the first antenna 212 and the second antenna 214 and between the third antenna 216 and the second antenna 214 may be calculated, for example, as follows: $\begin{matrix}{g}_{C _ ANT _ A 1} = \frac{{V}_{C _ ANT _ A 1}}{{V}_{C _ ANT _ A 2}} ⋅ \frac{{V}_{C _ RES _ A 2}}{{V}_{C _ RES _ A 1}} \\ {g}_{C _ ANT _ A 3} = \frac{{V}_{C _ ANT _ A 3}}{{V}_{C _ ANT _ A 2}} ⋅ \frac{{V}_{C _ RES _ A 2}}{{V}_{C _ RES _ A 3}}\end{matrix}$ (1)
where *g*_{*C*_*ANT*_*A*1} and *g*_{*C*_*ANT*_*A*3} represent the gains (e.g., complex valued gains) of the first and third antennas with respect to the second antenna, *V*_{*C*_*ANT*_*A*1}, *V*_{*C*_*ANT*_*A*2}, and *V*_{*C*_*ANT*_*A*3}, represent the voltage measurements (e.g., complex valued voltage measurements) in the first, second, and third antennas when the test loop is coupled with those antennas, and *V*_{*C*_*RES*_*A*1}, *V*_{*C*_*RES*_*A*2}, and *V*_{*C*_*RES*_*A*3} represent the voltage measurements (e.g., complex valued voltage measurements) across the normalizing resistor when the test loop is coupled with the first, second, and third antennas.

With continued reference to Equation 1, the gains are computed by taking a product to two ratios, a first ratio of the voltage in the measured (calibrated) antenna to the voltage in the reference antenna and a second ratio of the voltage in the normalizing resistor when the test loop is electromagnetically coupled with the reference antenna to the voltage in the normalizing resistor when the test loop is electromagnetically coupled with the measured (calibrated) antenna.

The above described antenna gain ratios or calibration coefficients (e.g., antenna gain calibration coefficients) are programmed into the measurement sub and used to correct electromagnetic measurements. The ratios given in Equation 1 may optionally be combined with other calibration coefficients to obtain corrected gain ratios. For example, further calibrations may be performed, before, during, or after operating the downhole tool to compute a gain calibrated electromagnetic measurement. The combined calibration may include additional corrections that may be calculated prior to or during the run as shown in the equations below: $\begin{matrix}{G}_{A 1} = {g}_{C _ PA _ A 1} ⋅ {g}_{C _ AHG _ A 1} ⋅ {g}_{C _ ALG _ A 1} ⋅ {g}_{C _ ANT _ A 1} \\ {G}_{A 3} = {g}_{C _ PA _ A 3} ⋅ {g}_{C _ AHG _ A 3} ⋅ {g}_{C _ ALG _ A 3} ⋅ {g}_{C _ ANT _ A 3}\end{matrix}$ (2)
where *G*_{*A*1} and *G*_{*A*3} represent the combined gain ratios for the first and third antennas, *g*_{*C*_*PA*_*A*1} and *g*_{*C*_*PA*_*A*3} represent a calibration of a preamp in the measurement sub, *g*_{*C*_*AHG*_*A*1} and *g*_{*C*_*AHG*_*A*3} represent a calibration of the acquisition board with high gain, and *g*_{*C*_*ALG*_*A*1} and *g*_{*C*_*ANT*_*A*3} represent a calibration of the acquisition board with low gain. For example, in some embodiments, a receiver sub may perform a self-test while operating downhole to account for temperature and/or other variations, and that resulting calibration or gain ratio, may be included in the overall gain real time to provide a more accurate calibration. While some calibrations have been described above, more or less calibrations can be combined with the antenna gain ratio calibration to arrive at an overall calibration/correction. As noted above, the calibrations may be done pre-run, during a run, post-run, or some combination thereof. As also described above, the voltages and gain ratios described above may be complex quantities including amplitude and phase information, however, the disclosed embodiments are not limited in this regard as the voltages and gain ratios may also be real quantities including only amplitude information.

It will be understood that the gain ratios in Equation 1 and 2 may be computed at each measurement frequency (e.g., at 1 kHz, 2 kHz, 3 kHz, 6 kHz, 12 kHz, 24 kHz, 48 kHz, 96 kHz, and/or 192 kHz or any other desired frequency) as described above. The downhole tool may be programmed to combine these gain ratios (as expressed in Equation 1 or 2) with the downhole electromagnetic measurements. For example, at any particular frequency, the measured voltages at the first, second, and third antennas may be calibrated, for example, as follows (in some embodiments including first, second, and third antennas such as described above with respect to FIG. 2B and 4): $\begin{matrix}{V}_{CAL _ A 1} = {G}_{A 1} ⋅ {V}_{MEAS _ A 1} \\ {V}_{CAL _ A 3} = {G}_{A 3} ⋅ {V}_{MEAS _ A 3} \\ {V}_{CAL _ A 2} = {V}_{MEAS _ A 2}\end{matrix}$ (3)
where *V*_{*CAL*_*A*1}, *V*_{*CAL*_*A*2}, and *V*_{*CAL*_*A*3} represent the calibrated voltages at the first, second, and third antennas, *V*_{*MEAS*_*A*1}, *V*_{*MEAS*_*A*2}, and *V*_{*MEAS*_*A*3} represent the measured voltages at the first, second, and third antenna, and *G*_{*A*1} and *G*_{*A*3} represent the gain ratios computed above. In this embodiment the measured voltages on the first and third antennas are calibrated with respect to second antenna (which acts in this example as the reference). The voltage on the second antenna is therefore not calibrated/corrected in this example.

Described above are embodiments for correcting the gain component of the antenna magnetic moment of a receiver sub. In some embodiments, in a similar manner as to correcting for the gain component of the antenna magnetic moment, the antenna tilt angle component may also be calculated and calibrated. In such embodiments, the voltage measurements (obtained using a test loop as described above and in more detail below) may first be processed to compute a tilt angle for each of the first and second or first, second, and third (and so on) antennas. The computed ratio then further includes a ratio of a function of the tilt angles (e.g., a ratio of the cosines of the tilt angles or a ratio of the sines of the tilt angles as described in more detail below).

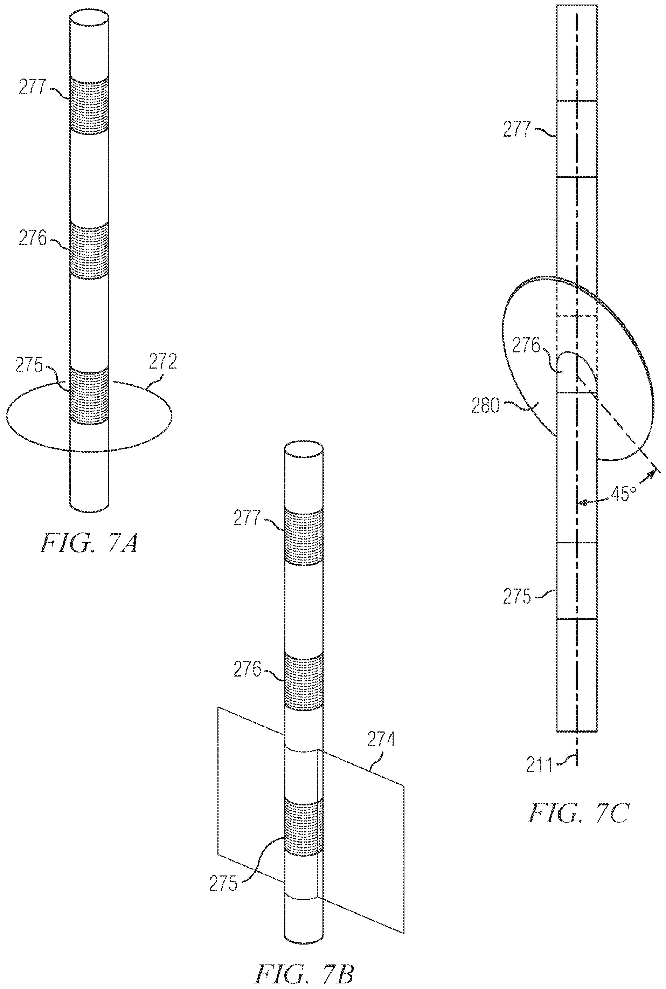

In some embodiments, the antenna tilt angle may be computed from voltage measurements obtained using two distinct test loops (that are angularly offset from one another) placed sequentially over the antennas. Example test loops are depicted on FIGS. 7A and 7B in which FIG. 7A depicts an axial test loop 272 deployed about tilted antenna 275 and FIG. 7B depicts a transverse test loop 274 deployed about antenna tilted 275. While the use of axial and transverse test loops may be advantageous, the disclosed embodiments are not so limited. In some embodiments, voltage measurements may be made, using a data acquisition system as described above, when the axial test loop 272 is deployed about the antenna 275. Voltage measurements may then be made with the transverse test loop 274 deployed about the antenna. Similar measurements may then be made other antennas such as antennas 276 and 277. These voltage measurements may then be processed to compute the antenna tilt angle, for example, as follows: ${Tilt}_{x} = {tan}^{- 1} \left(N⋅\frac{{V}_{C _ T _ x}}{{V}_{C _ A _ x}}\right)$ (4)
where *Tiltₓ* represents the tilt angle of antenna *x* (e.g., antenna 1, antenna 2, antenna 3, and so on), *V*_{*C*_*T*_*x*} represents the measured voltage when the antenna is coupled with the transverse test loop, *V*_{*C*_*A*_*x*} represents the measured voltage when the antenna is coupled with the axial test loop, and N represents a normalization factor that is a magnetic moment ratio between the axial test loop and the transverse test loop. It will be appreciated that N may be accurately determined from the test loop dimensions and the voltages in the normalizing resistor.

The gain ratios may then be computed, for example, as follows: $\begin{matrix}{g}_{C _ ANT _ A 1 _ Axial} = \frac{{V}_{C _ A _ 1}}{{V}_{C _ A _ 2}} ⋅ \frac{cos \left(Tilt1\right)}{cos \left(Tilt2\right)} ⋅ \frac{{V}_{C _ RES _ A _ 2}}{{V}_{C _ RES _ A _ 1}} \\ {g}_{C _ ANT _ A 1 _ Trans} = \frac{{V}_{C _ T _ 1}}{{V}_{C _ T _ 2}} ⋅ \frac{sin \left(Tilt1\right)}{sin \left(Tilt2\right)} ⋅ \frac{{V}_{C _ RES _ T _ 2}}{{V}_{C _ RES _ T _ 1}} \\ {g}_{C _ ANT _ A 1} = 0.5 \left({g}_{C _ ANT _ A 1 _ Axial}+{g}_{C _ ANT _ A 1 _ Trans}\right)\end{matrix}$ (5)
where *g*_{*C*_*ANT*_*A*1_*Axial*} and *g*_{*C*_*ANT*_*A*1_*Trans*} represent the gains (e.g., complex valued gains) of the first antenna with respect to the second antenna, *V*_{*C*_*A*_1}, *V*_{*C*_*A*_2}, *V*_{*C*_*T*_1}, and *V*_{*C*_*T*_2} are the coupling voltages (e.g., complex valued voltage measurements) as defined above with respect to Equation 4, and *V*_{*C*_*RES*_*A*_1}, *V*_{*C*_*RES*_*A*_2}, *V*_{*C*_*RES*_*T*_1}, and *V*_{*C*_*RES*_*T*_2} represent the voltage measurements (e.g., complex valued voltage measurements) across the normalizing resistor when the axial and transverse test loops are coupled with the first and second antennas. It will be appreciated that equation 5 may also be used to compute gains for a third (or fourth, etc.) antenna with respect to the second antenna simply by substituting the antenna 1 voltage measurements and tilt angle with antenna 3 voltage measurements and tilt angle (and so one).

In another embodiment, the tilt angles and gains (gain ratios) may be computed using a tilted test loop (a test loop whose moment is tilted with respect to the tool axis). One example of a tilted test loop is depicted on FIG. 7C in which a tilted test loop 280 is deployed about antenna 276 in an electromagnetic measurement tool including first, second, and third tilted antennas 275, 276, and 277. In the depicted embodiment, the tilted antenna 280 is tilted at an angle of 45 degrees with respect to the tool axis 211 as depicted (although the disclosed embodiments are not limited in this regard). Tilted test loops are described in more detail with respect to U.S. Patent Publication 2014/0156211.,

For example, the tilted test loop 280 may be deployed on an antenna as depicted on FIG. 7C. The tilted test loop may be rotated to multiple known azimuth angles about the measurement tool (about the antenna). Corresponding coupling voltages may be measured at each azimuth angle when the test loop and the antenna are electromagnetically coupled (as described above). The voltage measurements may be fit to a sine function (as a function of the azimuth angle) to compute the tilt angle of the antenna. This procedure may be performed for selected antennas on the measurement tool (e.g., the first, second, and third adjacent antennas as described above).

The gain ratios may then be computed, for example, as follows: ${g}_{C _ ANT _ A 1} = \frac{{V}_{C _ TTL 0 _ 1}}{{V}_{C _ TTL 0 _ 2}} ⋅ \frac{cos \left(45-Tilt{1}_{TTL}\right)}{cos \left(45-Tilt{2}_{TTL}\right)} ⋅ \frac{{V}_{{C}_{{RES}_{TTL {0}_{2}}}}}{{V}_{{C}_{{RES}_{TTL {0}_{1}}}}}$ (6)
where *Tilt*1*_{TTL}* and *Tilt*2*_{TTL}* represent the tilt angles of the first and second antennas as determined using the tilted test loop (as described above), *V*_{*C*_*TTL*0_1} and *V*_{*C*_*TTL*0_2} represent the coupling voltages measured (e.g., complex valued voltage measurements) when the tilted test loop is azimuthally (rotationally) aligned with and electromagnetically coupled with the first and second antennas, and *V*_{*C*_*RES*_*TTL*0_2} and *V*_{*C*_*RES*_*TTL*0_1} represent the voltage measurements (e.g., complex valued voltage measurements) across the normalizing resistor when the tilted test loop is azimuthally (rotationally) aligned with and electromagnetically coupled with the first and second antennas. It will be appreciated that equation 6 may also be used to compute gains for a third (or fourth, etc.) antenna with respect to the second antenna simply by substituting the antenna 1 voltage measurements and tilt angle with antenna 3 voltage measurements and tilt angle (and so one).

With continued reference to Equations 5 and 6, the gains are computed by taking a product of three ratios, a first ratio of the voltage in the measured (calibrated) antenna to the voltage in the reference antenna, a second ratio of the voltage in the normalizing resistor when the test loop is electromagnetically coupled with the reference antenna to the voltage in the normalizing resistor when the test loop is electromagnetically coupled with the measured (calibrated) antenna, and a third ratio of a function (e.g., a cosine or sine function) of the tilt angle of the first antenna to the same function of the tilt angle of the second antenna..

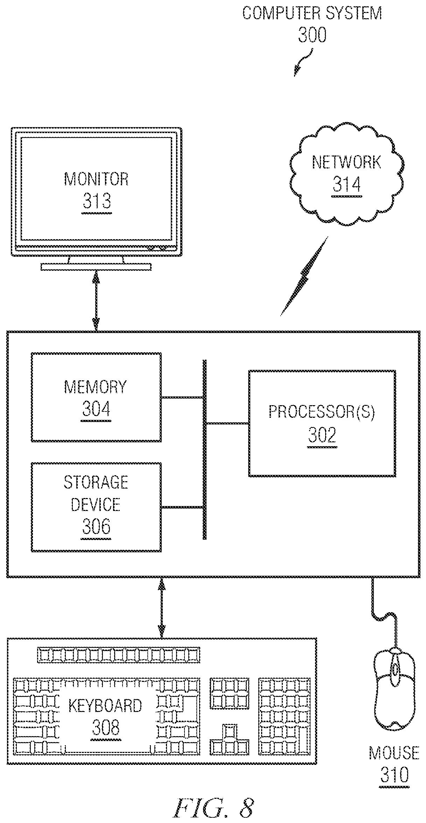

It will be appreciated that calibration of an electromagnetic logging tool (or a portion of the calibration), may be implemented on virtually any type of computer regardless of the platform being used. For example, as shown in FIG. 8, a computer system 300 includes one or more processor(s) 302, associated memory 304 (e.g., random access memory (RAM), cache memory, flash memory, etc.), a storage device 306 (e.g., a hard disk, an optical drive such as a compact disk drive or digital video disk (DVD) drive, a flash memory stick, etc.), and numerous other elements and functionalities typical of modern computers (not shown). The computer system 300 may also include input means, such as a keyboard 308, a mouse 310, or a microphone (not shown). Further, the computer system 300 may include output means, such as a monitor 312 (e.g., a liquid crystal display (LCD), a plasma display, or cathode ray tube (CRT) monitor) or printer (not shown). The computer system 300 may be connected to a network 314 (e.g., a local area network (LAN), a wide area network (WAN) such as the Internet, or any other similar type of network) with wired and/or wireless segments via a network interface connection (not shown). Those skilled in the art will appreciate that many different types of computer systems exist, and the aforementioned input and output means may take other forms. Generally speaking, the computer system 300 includes at least the minimal processing, input, and/or output means necessary to practice one or more of the disclosed embodiments.

Further, those skilled in the art will appreciate that one or more elements of the aforementioned computer system 300 may be located at a remote location and connected to the other elements over a network. For example, the computer system may be coupled to a downhole processor deployed in an electromagnetic logging tool via a telemetry channel such as a mud pulse telemetry channel or wired drill pipe. Further, one or more embodiments may be implemented on a distributed system having a plurality of nodes, where each portion may be located on a different node within the distributed system. In one or more embodiments, the node corresponds to a computer system. In some embodiments, the node may correspond to a processor with associated physical memory. The node may correspond to a processor with shared memory and/or resources. Further, software instructions for performing one or more embodiments of reservoir engineering may be stored on a computer readable medium such as a compact disc (CD), a diskette, a tape, or any other computer readable storage device.

The computer system may be configured to compute the various calibration factors, coefficients, and quantities described above. For example, the computer system may include instructions to receive voltage from corresponding receiving antennas and test loop antennas. The computer system may further include instructions to receive electromagnetic measurements from downhole tool memory (e.g., after retrieving the tool from the wellbore). The computer system may further include instructions to compute the functions that describe changes in effective area of a transmitter and/or receiver antenna with temperature and/or pressure. The computer system may further include instructions to compute calibration factors for the reference tool receiver and transmitter, for example, as described above. The computer system may include further instructions to process these calibration quantities in combination with electromagnetic measurements (e.g., received from downhole tool memory) to compute the calibrated measurements. Moreover, the calibration quantities may be processed in combination with downhole temperature and/or pressure measurements and the electromagnetic logging measurements to compute gain calibrated measurements as described above.

As also described above, the computed calibration factors, coefficients, and quantities may be stored in downhole memory and may then be applied to the electromagnetic measurements using a downhole processor (e.g., a processor deployed in the electromagnetic logging tool) to compute the calibrated measurements. For example, calibrations may be computed using computer system 300 and stored in downhole memory. A mathematical function describing changes in effective area of a transmitter and/or receiver antenna with temperature and/or pressure may also be stored in downhole memory. In such embodiments, the downhole processor may be configured to process downhole temperature and/or pressure measurements in combination with the calibration quantities stored in memory to compute temperature and/or pressure corrected quantities. The downhole processor may be further configured to multiply selected electromagnetic logging measurements by the corrected quantities and/or by the original calibration quantities to compute the gain calibrated electromagnetic logging measurements downhole.

When gain calibrated measurements are used in a while drilling tool, those measurements may be used to determine information about the wellbore. Using that determined information, changes may be made to drilling. For example, in some embodiments a downhole tool may be a geosteering tool and may be able to automatically follow a trajectory adjacent to a formation boundary. In some embodiments, the corrected measurements may be sent uphole, analyzed, and a driller or an autodriller may modify the drilling plan, e.g., by steering in a different direction.

The embodiments of the calibration system and method have been primarily described with reference for use with LWD resistivity tools; calibration system and method may be used in applications other than the drilling of a wellbore. In other embodiments, calibration systems according to the present disclosure may be used in wireline operations, however, other potential uses can be envisioned. Accordingly, the terms "wellbore," "borehole" and the like should not be interpreted to limit tools, systems, assemblies, or methods of the present disclosure to any particular industry, field, or environment.

One or more specific embodiments of the present disclosure are described herein. These described embodiments are examples of the presently disclosed techniques. Additionally, in an effort to provide a concise description of these embodiments, not all features of an actual embodiment may be described in the specification. It should be appreciated that in the development of any such actual implementation, as in any engineering or design project, numerous embodiment-specific decisions will be made to achieve the developers' specific goals, such as compliance with system-related and business-related constraints, which may vary from one embodiment to another. Moreover, it should be appreciated that such a development effort might be complex and time consuming, but would nevertheless be a routine undertaking of design, fabrication, and manufacture for those of ordinary skill having the benefit of this disclosure.

Additionally, it should be understood that references to "one embodiment" or "an embodiment" of the present disclosure are not intended to be interpreted as excluding the existence of additional embodiments that also incorporate the recited features. For example, any element described in relation to an embodiment herein may be combinable with any element of any other embodiment described herein. Numbers, percentages, ratios, or other values stated herein are intended to include that value, and also other values that are "about" or "approximately" the stated value, as would be appreciated by one of ordinary skill in the art encompassed by embodiments of the present disclosure. A stated value should therefore be interpreted broadly enough to encompass values that are at least close enough to the stated value to perform a desired function or achieve a desired result. The stated values include at least the variation to be expected in a suitable manufacturing or production process, and may include values that are within 5%, within 1%, within 0.1%, or within 0.01% of a stated value.

A person having ordinary skill in the art should realize in view of the present disclosure that equivalent constructions do not depart from the scope of the present invention and that various changes, substitutions, and alterations may be made to embodiments disclosed herein without departing from the scope of the present invention as defined in the claims.

The terms "approximately," "about," and "substantially" as used herein represent an amount close to the stated amount that is within standard manufacturing or process tolerances, or which still performs a desired function or achieves a desired result. For example, the terms "approximately," "about," and "substantially" may refer to an amount that is within less than 5% of, within less than 1% of, within less than 0.1% of, and within less than 0.01% of a stated amount. Further, it should be understood that any directions or reference frames in the preceding description are merely relative directions or movements. For example, any references to "up" and "down" or "above" or "below" are merely descriptive of the relative position or movement of the related elements.

## Claims

1. A method of calibrating an electromagnetic measurement tool, the method comprising:
(a) deploying (152) a test loop (220) about a first antenna in the electromagnetic measurement tool (210);
(b) electromagnetically coupling (154) the test loop (220) and the first antenna (212);
(c) measuring (156) a first voltage in the first antenna (212) or in the test loop (220) induced by the electromagnetically coupling the test loop (220) and the first antenna (212);
(d) deploying (158) the test loop (220) about a second antenna (214) in the electromagnetic measurement tool (210);
(e) electromagnetically coupling (160) the test loop (220) and the second antenna (214);
(f) measuring (162) a second voltage in the second antenna (214) or in the test loop (220) induced by said electromagnetically coupling the test loop (220) and the second antenna (214);
**characterized in**
(g) computing (164) a ratio of the first voltage to the second voltage;
(h) calibrating electromagnetic measurements made with the first antenna (212) to electromagnetic measurements made with the second antenna (214) using the computed ratio by:
(h1) storing the ratio to memory in the electromagnetic measurement tool (210);
(h2) deploying the electromagnetic measurement tool (210) in a subterranean wellbore;
(h3) causing the electromagnetic measurement tool (210) to make first electromagnetic measurements with the first antenna (212) and second electromagnetic measurements with the second antenna (214) while deployed in the wellbore; and
(h4) multiplying the first electromagnetic measurements by the ratio to obtain calibrated first electromagnetic measurements.

2. The method of claim 1, wherein steps (a) and (d) further comprise lifting the electromagnetic measurement tool and the test loop up and away from a floor, walls, and other electrically conducting materials.

3. The method of claim 1, wherein the test loop (220) is an axial test loop, having a moment axis coincident with an axis (211) of the electromagnetic measurement tool (210), and the first and second antennas (212, 214) are tilted antennas.

4. The method of claim 3, wherein the first and second tilted antennas are rotationally offset from one another on the electromagnetic measurement tool (210).

5. The method of claim 1, wherein:
step (b) comprises applying a first alternating electric current to the test loop (220) or the first antenna (212); and
step (e) comprises applying a second alternating electric current to the test loop (220) or the second antenna (214).

6. The method of claim 5, wherein:
step (b) further comprises applying the first alternating electric current to (i) the test loop (220) or the first antenna (212) and to (ii) a normalizing resistor (242) that is in series with the test loop (220) or the first antenna (212); and
step (e) further comprises applying the second alternating electric current to (i) the test loop (220) or the second antenna (242) and (ii) the normalizing resistor (242) that is in series with the test loop (220) or the second antenna (214).

7. The method of claim 6, wherein:
step (c) further comprises measuring a first resistor voltage in the normalizing resistor (242) caused by the applying the first alternating electric current to the normalizing resistor (242); and
step (f) further comprises measuring a second resistor voltage in the normalizing resistor (242) caused by the applying the second alternating electric current to the normalizing resistor (242).

8. The method of claim 7, wherein the ratio computed in (g) is a product of a first ratio and a second ratio, the first ratio being a ratio of the first voltage to second voltage and the second ratio being a ratio of the second resistor voltage to the first resistor voltage; or
wherein the ratio computed in (g) is a product of first, second, and third ratios, the first ratio being a ratio of the first voltage to the second voltage, the second ratio being a ratio of the second resistor voltage to the first resistor voltage, and the third ratio being a ratio of a function of a tilt angle of the first antenna and the function of a tilt angle of the second antenna.

9. The method of claim 1, further comprising:
repeating steps (b), (c), (e), and (f) at a plurality of distinct electromagnetic frequencies.

10. The method of claim 1, wherein (g) further comprises:
processing the first voltage to compute a first tilt angle of the first antenna (212);
processing the second voltage to compute a second tilt angle of the second antenna (214); and
wherein computing the ratio further comprises computing a ratio of a function of the first tilt angle to the function of the second tilt angle.

11. The method of claim 10, wherein:
the test loop is a tilted test loop (280);
the test loop (280) is deployed at a plurality of azimuthal angles about the first and second antennas (275) in steps (a) and (d); and
the first and second voltages comprise a corresponding plurality of first and second voltages measured at the plurality of azimuthal angles.

12. The method of claim 10, wherein:
the test loop (220) comprises a first axial test loop (272) and a second transverse test loop (274); and
the first voltage comprises first and second first voltages corresponding to the first and second test loops (272, 274) and the second voltage comprises first and second voltages corresponding to the first and second test loops (272, 274).

## Patentansprüche

1. Verfahren zum Kalibrieren eines Werkzeugs für elektromagnetische Messung, das Verfahren umfassend:
(a) Einsetzen (152) einer Prüfschleife (220) um eine erste Antenne in dem Werkzeug für elektromagnetische Messung (210);
(b) elektromagnetisch Koppeln (154) der Prüfschleife (220) und der ersten Antenne (212);
(c) Messen (156) einer ersten Spannung in der ersten Antenne (212) oder in der Prüfschleife (220), die durch das elektromagnetisch Koppeln der Prüfschleife (220) und der ersten Antenne (212) induziert wird;
(d) Einsetzen (158) der Prüfschleife (220) um eine zweite Antenne (214) in dem Werkzeug für elektromagnetische Messung (210);
(e) elektromagnetisch Koppeln (160) der Prüfschleife (220) und der zweiten Antenne (214);
(f) Messen (162) einer zweiten Spannung in der zweiten Antenne (214) oder in der Prüfschleife (220), die durch das elektromagnetisch Koppeln der Prüfschleife (220) und der zweiten Antenne (214) induziert wird;
**gekennzeichnet durch**
(g) Berechnen (164) eines Verhältnisses der ersten Spannung zu der zweiten Spannung;
(h) Kalibrieren von elektromagnetischen Messungen, die mit der ersten Antenne (212) durchgeführt wurden, auf elektromagnetische Messungen, die mit der zweiten Antenne (214) durchgeführt wurden, unter Verwendung des berechneten Verhältnisses **durch**:
(h1) Speichern des Verhältnisses in einem Speicher in dem Werkzeug für elektromagnetische Messung (210);
(h2) Einsetzen des Werkzeugs für elektromagnetische Messung (210) in eine unterirdische Bohrung;
(h3) Veranlassen des Werkzeugs für elektromagnetische Messung (210), erste elektromagnetische Messungen mit der ersten Antenne (212) und zweite elektromagnetische Messungen mit der zweiten Antenne (214) durchzuführen, während es in der Bohrung eingesetzt ist; und
(h4) Multiplizieren der ersten elektromagnetischen Messungen mit dem Verhältnis, um kalibrierte erste elektromagnetische Messungen zu erhalten.

2. Verfahren nach Anspruch 1, wobei die Schritte (a) und (d) ferner ein Anheben des Werkzeugs für elektromagnetische Messung und der Prüfschleife nach oben und weg von einem Boden, Wänden und anderen elektrisch leitfähigen Materialien umfassen.

3. Verfahren nach Anspruch 1, wobei die Prüfschleife (220) eine axiale Prüfschleife ist, die eine Momentenachse, die mit einer Achse (211) des Werkzeugs für elektromagnetische Messung (210) zusammenfällt, aufweist, und die erste und die zweite Antenne (212, 214) geneigte Antennen sind.

4. Verfahren nach Anspruch 3, wobei die erste und die zweite geneigte Antenne auf dem Werkzeug für elektromagnetische Messung (210) voneinander drehversetzt sind.

5. Verfahren nach Anspruch 1, wobei:
Schritt (b) ein Anlegen eines ersten elektrischen Wechselstroms an die Prüfschleife (220) oder die erste Antenne (212) umfasst; und
Schritt (e) das Anlegen eines zweiten elektrischen Wechselstroms an die Prüfschleife (220) oder die zweite Antenne (214) umfasst.

6. Verfahren nach Anspruch 5, wobei:
Schritt (b) ferner das Anlegen des ersten elektrischen Wechselstroms an (i) die Prüfschleife (220) oder die erste Antenne (212) und an (ii) einen Normierwiderstand (242), der mit der Prüfschleife (220) oder der ersten Antenne (212) in Reihe geschaltet ist, umfasst; und
Schritt (e) ferner das Anlegen des zweiten elektrischen Wechselstroms an (i) die Prüfschleife (220) oder die zweite Antenne (242) und an (ii) den Normierwiderstand (242), der mit der Prüfschleife (220) oder der zweiten Antenne (214) in Reihe geschaltet ist, umfasst.

7. Verfahren nach Anspruch 6, wobei:
Schritt (c) ferner das Messen einer ersten Widerstandsspannung in dem Normierwiderstand (242), die durch das Anlegen des ersten elektrischen Wechselstroms an den Normierwiderstand (242) veranlasst wird, umfasst; und
Schritt (f) ferner das Messen einer zweiten Widerstandsspannung in dem Normierwiderstand (242), die durch das Anlegen des zweiten elektrischen Wechselstroms an den Normierwiderstand (242) veranlasst wird, umfasst.

8. Verfahren nach Anspruch 7, wobei das in (g) berechnete Verhältnis ein Produkt aus einem ersten Verhältnis und einem zweiten Verhältnis ist, das erste Verhältnis ein Verhältnis der ersten Spannung zu der zweiten Spannung ist und das zweite Verhältnis ein Verhältnis der zweiten Widerstandsspannung zu der ersten Widerstandsspannung ist; oder
wobei das in (g) berechnete Verhältnis ein Produkt aus dem ersten, dem zweiten und dem dritten Verhältnis ist, das erste Verhältnis ein Verhältnis der ersten Spannung zu der zweiten Spannung ist, das zweite Verhältnis ein Verhältnis der zweiten Widerstandsspannung zu der ersten Widerstandsspannung ist, und das dritte Verhältnis ein Verhältnis einer Funktion eines Neigungswinkels der ersten Antenne und der Funktion eines Neigungswinkels der zweiten Antenne ist.

9. Verfahren nach Anspruch 1, ferner umfassend:
Wiederholen der Schritte (b), (c), (e) und (f) bei einer Vielzahl von unterschiedlichen elektromagnetischen Frequenzen.

10. Verfahren nach Anspruch 1, wobei (g) ferner umfasst:
Verarbeiten der ersten Spannung, um einen ersten Neigungswinkel der ersten Antenne (212) zu berechnen;
Verarbeiten der zweiten Spannung, um einen zweiten Neigungswinkel der zweiten Antenne (214) zu berechnen; und
wobei das Berechnen des Verhältnisses ferner das Berechnen eines Verhältnisses einer Funktion des ersten Neigungswinkels zu der Funktion des zweiten Neigungswinkels umfasst.

11. Verfahren nach Anspruch 10, wobei:
die Prüfschleife eine geneigte Prüfschleife (280) ist;
die Prüfschleife (280) in den Schritten (a) und (d) in einer Vielzahl von Azimutwinkeln um die erste und die zweite Antenne (275) eingesetzt wird; und
die erste und die zweite Spannung eine entsprechende Vielzahl von ersten und zweiten Spannungen, gemessen in der Vielzahl von Azimutwinkeln, umfassen.

12. Verfahren nach Anspruch 10, wobei:
die Prüfschleife (220) eine erste axiale Prüfschleife (272) und eine zweite transversale Prüfschleife (274) umfasst; und
die erste Spannung erste und zweite erste Spannungen, die der ersten und der zweiten Prüfschleife (272, 274) entsprechen, umfasst und die zweite Spannung erste und zweite Spannungen, die der ersten und der zweiten Prüfschleife (272, 274) entsprechen, umfasst.

## Revendications

1. Procédé d'étalonnage d'un outil de mesure électromagnétique, le procédé comprenant :
(a) le déploiement (152) d'une boucle de test (220) autour d'une première antenne dans l'outil de mesure électromagnétique (210) ;
(b) le couplage électromagnétique (154) de la boucle de test (220) et de la première antenne (212) ;
(c) la mesure (156) d'une première tension dans la première antenne (212) ou dans la boucle de test (220) induite par le couplage électromagnétique de la boucle de test (220) et de la première antenne (212) ;
(d) le déploiement (158) de la boucle de test (220) autour d'une seconde antenne (214) dans l'outil de mesure électromagnétique (210) ;
(e) le couplage électromagnétique (160) de la boucle de test (220) et de la seconde antenne (214) ;
(f) la mesure (162) d'une seconde tension dans la seconde antenne (214) ou dans la boucle de test (220) induite par ledit couplage électromagnétique de la boucle de test (220) et de la seconde antenne (214) ;
**caractérisé en**
(g) calcul (164) d'un rapport de la première tension sur la seconde tension ;
(h) étalonnage de mesures électromagnétiques effectuées avec la première antenne (212) par rapport à des mesures électromagnétiques effectuées avec la seconde antenne (214) à l'aide du rapport calculé par :
(h1) le stockage du rapport en mémoire dans l'outil de mesure électromagnétique (210) ;
(h2) déploiement de l'outil de mesure électromagnétique (210) dans un puits de forage souterrain ;
(h3) fait d'amener l'outil de mesure électromagnétique (210) à effectuer des premières mesures électromagnétiques avec la première antenne (212) et des secondes mesures électromagnétiques avec la seconde antenne (214) tout en étant déployé dans le puits de forage ; et
(h4) multiplication des premières mesures électromagnétiques par le rapport pour obtenir des premières mesures électromagnétiques étalonnées.

2. Procédé selon la revendication 1, dans lequel les étapes (a) et (d) comprennent en outre le soulèvement de l'outil de mesure électromagnétique et de la boucle de test vers le haut et à l'écart d'un sol, de murs et d'autres matériaux électriquement conducteurs.

3. Procédé selon la revendication 1, dans lequel la boucle de test (220) est une boucle de test axiale, ayant un axe de moment coïncidant avec un axe (211) de l'outil de mesure électromagnétique (210), et les première et seconde antennes (212, 214) sont des antennes inclinées.

4. Procédé selon la revendication 3, dans lequel les première et seconde antennes inclinées sont décalées en rotation l'une par rapport à l'autre sur l'outil de mesure électromagnétique (210).

5. Procédé selon la revendication 1, dans lequel :
l'étape (b) comprend l'application d'un premier courant électrique alternatif à la boucle de test (220) ou à la première antenne (212) ; et
l'étape (e) comprend l'application d'un second courant électrique alternatif à la boucle de test (220) ou à la seconde antenne (214).

6. Procédé selon la revendication 5, dans lequel :
l'étape (b) comprend en outre l'application du premier courant électrique alternatif à (i) la boucle de test (220) ou la première antenne (212) et à (ii) une résistance de normalisation (242) qui est en série avec la boucle de test (220) ou la première antenne (212) ; et
l'étape (e) comprend en outre l'application du second courant électrique alternatif à (i) la boucle de test (220) ou la seconde antenne (242) et (ii) la résistance de normalisation (242) qui est en série avec la boucle de test (220) ou la seconde antenne (214).

7. Procédé selon la revendication 6, dans lequel :
l'étape (c) comprend en outre la mesure d'une première tension de résistance dans la résistance de normalisation (242) provoquée par l'application du premier courant électrique alternatif à la résistance de normalisation (242) ; et
l'étape (f) comprend en outre la mesure d'une seconde tension de résistance dans la résistance de normalisation (242) provoquée par l'application du second courant électrique alternatif à la résistance de normalisation (242).

8. Procédé selon la revendication 7, dans lequel le rapport calculé en (g) est un produit d'un premier rapport et d'un deuxième rapport, le premier rapport étant un rapport de la première tension sur la seconde tension et le deuxième rapport étant un rapport de la seconde tension de résistance sur la première tension de résistance ; ou
dans lequel le rapport calculé en (g) est un produit de premier, deuxième et troisième rapports, le premier rapport étant un rapport de la première tension sur la seconde tension, le deuxième rapport étant un rapport de la seconde tension de résistance sur la première tension de résistance, et le troisième rapport étant un rapport d'une fonction d'un angle d'inclinaison de la première antenne et de la fonction d'un angle d'inclinaison de la seconde antenne.

9. Procédé selon la revendication 1, comprenant en outre :
la répétition des étapes (b), (c), (e) et (f) au niveau d'une pluralité de fréquences électromagnétiques distinctes.

10. Procédé selon la revendication 1, dans lequel (g) comprend en outre :
le traitement de la première tension pour calculer un premier angle d'inclinaison de la première antenne (212) ;
le traitement de la seconde tension pour calculer un second angle d'inclinaison de la seconde antenne (214) ; et
dans lequel le calcul du rapport comprend en outre le calcul d'un rapport d'une fonction du premier angle d'inclinaison sur la fonction du second angle d'inclinaison.

11. Procédé selon la revendication 10, dans lequel :
la boucle de test est une boucle de test inclinée (280) ;
la boucle de test (280) est déployée au niveau d'une pluralité d'angles azimutaux autour des première et seconde antennes (275) aux étapes (a) et (d) ; et
les première et seconde tensions comprennent une pluralité correspondante de première et seconde tensions mesurées au niveau de la pluralité d'angles azimutaux.

12. Procédé selon la revendication 10, dans lequel :
la boucle de test (220) comprend une première boucle de test axiale (272) et une seconde boucle de test transversale (274) ; et
la première tension comprend des première et seconde première tensions correspondant aux première et seconde boucles de test (272, 274) et la seconde tension comprend des première et seconde tensions correspondant aux première et seconde boucles de test (272, 274).
